# FASCICULE DE BREVET EUROPEEN

(11) **EP 1 649 734 B1**
(45) Date de publication et mention de la délivrance du brevet: **15.11.2006**
(21) Numéro de dépôt: 04767817.2
(22) Date de dépôt: 29.07.2004
(51) Int. Cl.: H05K 3/28

(54) **PROCEDE ET DISPOSITIF DE REMPLISSAGE PAR UN PRODUIT VISQUEUX DE ZONES SITUEES EN CREUX OU INTERPISTES SUR UN CIRCUIT IMPRIME, ET EQUIPEMENT UTILISANT UN TEL DISPOSITIF**
VERFAHREN UND EINRICHTUNG ZUM FÜLLEN VON IN HOHLRÄUMEN ANGEORDNETEN BEREICHEN ODER ZWISCHEN SPUREN MIT EINEM VISKOSEM PRODUKT AUF EINER LEITERPLATTE UND GERÄT MIT DER EINRICHTUNG
METHOD AND DEVICE FOR FILLING AREAS SITUATED IN HOLLOWS OR BETWEEN TRACKS WITH A VISCOUS PRODUCT ON A PRINTED CIRCUIT BOARD AND EQUIPMENT USING SAID DEVICE

(30) Priorité: 30.07.2003 FR 0309351; 02.04.2004 FR 0403455
(43) Date de publication de la demande: 26.04.2006
(73) Titulaire: Novatec, 82000 Montauban (FR)
(72) Inventeur: BOURRIERES, Francis, 82000 Montauban (FR); KAISER, Clément, 82000 Montauban (FR); CICERO, Antonio, 21040 Castronno (IT); NOVELLO, Osvaldo, 21040 Castronno (IT)
(74) Mandataire: Thurgood, Alexander John
(86) Numéro de dépôt international: PCT/FR2004/002043
(87) Numéro de publication internationale: WO 2005/011877

(56) Documents cités:
- EP-A- 1 303 172
- WO-A-01/49422
- FR-A- 2 845 858
- US-A1- 2002 162 685
- US-A1- 2003 057 264
- PATENT ABSTRACTS OF JAPAN vol. 018, no. 176 (C-1183), 25 mars 1994 (1994-03-25) -& JP 05 337425 A (IBIDEN CO LTD), 21 décembre 1993 (1993-12-21)

## Description

### DOMAINE D'APPLICATION

La présente invention concerne un dispositif de remplissage de zones situées en creux par rapport à une surface, avec un produit liquide plus ou moins visqueux, par extraction de l'air ou du gaz présent dans la zone en creux et par remplacement avec du produit de remplissage. Généralement ces zones sont de grande longueur, étroites, et profondes. A titre d'exemple, l'invention trouve son application pour la réalisation de circuits imprimés de puissance comme ceux utilisés dans le secteur automobile. En effet, il existe des applications pour lesquelles des substrats comportant des pistes conductrices par exemple en cuivre et ayant une épaisseur supérieures à 100 microns (micromètres) (typiquement de l'ordre de 400 microns) sont utilisés. Dans ces applications, il est nécessaire de remplir les zones inter-pistes avec un produit diélectrique, ce remplissage devant être sans bulles afin d'obtenir les caractéristiques électriques optimales et en surépaisseur strictement au niveau des zones en creux. De plus, les zones inter-pistes ne sont pas forcément fermées. Après' cette opération de remplissage les circuits imprimés subissent un cycle de polymérisation suivi d'un brossage.

### ETAT DE L'ART ANTERIEUR

Pour effectuer ce remplissage, l'homme de l'art utilise des techniques à sa disposition, à savoir l'enduction au rouleau ou la sérigraphie à l'aide d'une racle. Ces procédés consistent à pousser le produit à transférer à l'avant d'un rouleau ou d'une racle inclinée de manière à générer une surpression dans le produit en vu de le forcer à remplir les zones en creux. Les problèmes avec ces dispositifs de l'art antérieur sont de deux ordres :
- le premier réside dans le fait que dans certaines zones situées en creux et non débouchantes sur l'autre face, l'air reste prisonnier et empêche le produit de les remplir complètement. Pour obvier à ce problème avec les dispositifs de l'art antérieur, on est obligé de faire de multiples passages de racle ou de rouleau afin d'obtenir un remplissage sans toutefois obtenir réellement satisfaction car le produit n'est pas en surépaisseur au niveau des zones en creux et contient toujours de l'air, évidement ces passages multiples génèrent des temps de cycle incompatibles avec les productions en grande série.
- le deuxième est lié au fait que le produit est ré-entraîné par l'élément de remplissage, ce qui a tendance à creuser les dépôts en particulier s'ils sont de grande dimension ou si le produit présente une viscosité importante. Ce problème est particulièrement criant lorsqu'on utilise un rouleau de transfert.

Des dispositifs visant à remplir des trous borgnes ont été proposés par le passé. La demande de brevet PCT/FROO. 03494 du même déposant en est un exemple. Cette technique consiste à déplacer deux fentes sur la surface du substrat à remplir. La première fente est reliée à un générateur de vide alors que la deuxième contient le produit de remplissage. La première fente est à la fois distante de l'extérieur et de la deuxième fente d'une distance supérieure à la plus grande ouverture présente sur le substrat, la distance étant mesurée parallèlement au sens de déplacement. Dans ce cas, le dispositif est obligatoirement en contact étanche avec le substrat, sinon le remplissage du trou borgne ne pourra pas s'effectuer de façon complète. Cette technique est uniquement applicable à des cavités borgnes dont le périmètre sur la surface de remplissage représente une zone fermée- De plus, l'obtention du vide est extrêmement difficile à obtenir et à maintenir sur des substrats de dimension importante et pouvant présenter des irrégularités en surface.

Il existe des dispositifs de sérigraphie permettant de remplir des trous débouchant dans des substrats avec des produits pâteux et à travers un masque de sérigraphie. Ainsi le brevet US6,533,162 décrit ce type de dispositif dans lequel il est fait usage d'un rouleau en rotation et en translation sur le masque de manière à conférer une surpression à la crème à braser à l'avant du rouleau selon le mouvement du dispositif par rapport au substrat afin de remplir le trou en chassant l'air par la face inférieure du substrat. Un inconvénient majeur de ce type de dispositif réside dans le fait que le produit transféré grâce au rouleau est ré-entraîné à l'arrière de ce dernier. Dans le cas décrit dans ce brevet, de par la présence du pochoir, de par la faible dimension des trous et de la rhéologie de la crème à braser, le ré-entraînement de crème à l'arrière du rouleau est limité et ne nuit pas à la qualité du remplissage. Par contre, cette technique n'est pas applicable au remplissage avec un produit liquide ou plus ou moins pâteux de zones en creux non débouchantes sur l'autre face pouvant s'étendre sur de grandes longueurs, c'est à dire de plusieurs millimètres voir de plusieurs centimètres ou décimètres et pouvant présenter un ratio d'aspect défini par la profondeur de la zone relativement à la surface divisée par la plus petite dimension d'ouverture, inférieur à 1. En effet, dans ce cas, le produit de remplissage est ré-entraîné d'une part par la partie arrière du rouleau qui, comme on peut le voir, est exposé à l'air ambiant et d'autre part par la racle inclinée. De plus, cette invention n'est pas applicable à des zones en creux qui ne sont pas débouchantes, car il n'est fait état d'aucun moyen pour extraire le gaz présent dans les zones en creux.

Il est à noter que dans ce brevet le rouleau et la racle située à l'arrière agissent de façon successives et indépendantes. Dans un premier temps, le rouleau va permettre d'appliquer une pression sur le produit situé sur sa partie avant selon le mouvement du dispositif par rapport au substrat maintenu fixe, puis dans un deuxième temps, la racle inclinée va appliquer une seconde pression sur le produit situé sur sa partie avant selon le mouvement du dispositif par rapport au substrat maintenu fixe, ce qui a pour effet de maintenir des bulles dans les tranchées et de creuser les dépôts.

Le brevet US3,921,521 décrit un dispositif de sérigraphie d'encre sur des substrats tissés tels que des tapis. Dans ce brevet, il est fait état d'un cylindre en rotation qui permet de générer une surpression hydrostatique dans une zone inférieure du dispositif, grâce à un effet hydrodynamique. Le but dans ce brevet est de créer une surpression au niveau de la zone de transfert de manière à forcer l'encre à traverser l'écran et à pénétrer le substrat tissé en chassant l'air par le bas et les cotés. Ainsi, cette invention est applicable à des substrats poreux, mais n'est par contre pas applicable au remplissage de zones en creux qui ne sont pas débouchantes. En effet, il n'est prévu aucun dispositif pour évacuer l'air présent dans les zones en creux. L'utilisation de ce dispositif pour remplir des zones en creux non débouchantes conduirait à comprimer l'air présent dans la zone en creux lors du passage du dispositif au droit de la zone mais ne permettrait en aucun cas un remplissage total et exempt de bulles d'air.

De façon générale, il apparaît que l'effet hydrodynamique est un moyen connu pour forcer le passage au travers d'un masque de sérigraphie en vue de transférer un produit mais que ce moyen isolé n'est pas suffisant pour s'affranchir de l'enlèvement des bulles d'air et déposer en surépaisseur ce qui est précisément le but de l'invention.

Le brevet US 2002/162685 au nom de GOTRO JEFFREY ET AL décrit un circuit imprimé multicouches dont le moyen de remplissage des zones en creux consiste en une tête de dispense sous laquelle défilent les circuits à remplir et alimentée en produit diélectrique pompé dans un réservoir via un dispositif. Ainsi, le produit diélectrique arrive en surpression dans la tête de transfert de manière à pouvoir extruder le produit entre les lèvres de la tête. La racle disposée à l'arrière de la tête de dispense permet seulement de racler l'excès de produit. La pompe située à l'extérieur de la tête de transfert ne permet uniquement de générer qu'une surpression dans la canalisation et dans la tête de manière à pouvoir extruder le produit de cette dernière.

Le brevet US 2002/1626852003/057264 au nom de FUKASAWA HIDEYUKI ET AL décrit un dispositif visant à remplir des trous débouchant et à enduire des plages d'accueil et non à remplir des zones en creux non débouchantes. En fait , ce dispositif a pour objet de créer une force de transfert aussi importante que possible, ce qu'il obtient par l'écrasement du produit grâce au rouleau de sorte que l'air présent dans les trous traversants est évacué par le bas du trou débouchant.

### DESCRIPTION DE L'INVENTION

La présente invention vise à remplir sans bulle d'air et en surépaisseur strictement au niveau des zones en creux directement sur un circuit imprimé sans écran ou pochoir de sérigraphie, par un produit liquide ou pâteux plus ou moins visqueux, des interpistes ou des zones situées en creux par rapport à la surface du substrat et plus particulièrement des zones non débouchantes sur la face opposée et dont la longueur peut être très importante et/ou ayant un ratio d'aspect, défini par la profondeur de la zone relativement à la surface du substrat divisée par la plus petite dimension d'ouverture, inférieur ou égal à 1, comme par exemple des zones situées entre des pistes de cuivre.

Selon l'invention, le procédé de remplissage direct sans bulle d'air et en surépaisseur d'interpistes ou de zones situées en creux par rapport à la surface d'un substrat ou d'un circuit imprimé par un produit visqueux est remarquable en ce qu'il consiste :
- à mettre en mouvement le produit de remplissage au niveau des zones à remplir par un moyen de mise en mouvement de manière à évacuer sous forme de bulles, le gaz présent dans les zones en creux et de le substituer par du produit de remplissage,
- et à régler l'épaisseur de produit à la surface du substrat.

Préalablement à l'étape de mise en mouvement du produit au niveau des zones à remplir, le procédé de l'invention propose aussi de rendre étanche la zone à remplir à toute entrée de gaz extérieur à la zone, en étalant le produit à la surface du substrat de manière à isoler les zones à remplir du gaz extérieur et de mettre le produit à disposition. Ainsi, l'étanchéité est assurée en maintenant la zone à remplir recouverte de produit à partir du début du remplissage jusqu'au raclage de l'excès ou au réglage de l'épaisseur de produit à la surface du substrat de sorte que le produit de remplissage est mis en mouvement au niveau de la zone à remplir en évitant tout contact ultérieur avec du gaz extérieur à la zone à remplir. A aucun moment à partir de l'étalement du produit de remplissage jusqu'au réglage de l'épaisseur qui peut aller jusqu'au raclage total de l'excès, la zone à remplir ne doit être en contact avec du gaz provenant de l'extérieur de la zone à remplir.

En accord avec les actions fondamentales qui régissent le principe de substitution de l'air par du produit de remplissage, le procédé objet de la présente invention peut donc être décomposé en trois étapes dans sa mise en oeuvre.

La première étape consiste à étaler du produit de remplissage sur la surface du substrat de façon à d'une part, isoler le gaz présent dans les zones à remplir de l'extérieur et d'autre part, de mettre à disposition suffisamment de produit en vue d'effectuer le remplissage et éventuellement le réglage de l'épaisseur de produit sur la surface du substrat.

La deuxième étape consiste à mettre le produit de remplissage en mouvement au niveau des zones à remplir dans le substrat, permettant ainsi de créer une circulation forcée de produit au niveau de la zone à remplir de manière à extraire le gaz sous forme de bulles. Au fur et à mesure de l'extraction du gaz, le volume correspondant est remplacé par du produit de remplissage précédemment étalé. La mise en mouvement du produit de remplissage a pour conséquence d'entraîner le gaz présent dans les zones en creux sous forme de bulles et de permettre ainsi son remplacement par du produit.

La troisième étape consiste à enlever le surplus de produit ou à régler l'épaisseur désirée à la surface du substrat, cette épaisseur pouvant être nulle.

Selon une autre caractéristique de l'invention, la mise en mouvement du produit au niveau de la zone à remplir est obtenue par un effet hydrodynamique et de préférence par l'effet hydrodynamique d'un rouleau en rotation dont l'axe est perpendiculaire au mouvement du substrat par rapport au dispositif et parallèle au substrat et tel que le mouvement tangentiel du rouleau au niveau de la zone à remplir est opposé au sens de déplacement relatif du substrat par rapport au dispositif. De cette façon, l'adhérence du produit visqueux sur le rouleau génère, par un effet hydrodynamique, une mise en mouvement du produit de remplissage. Le mouvement est d'autant plus important que la distance par rapport au rouleau est faible. A la surface du rouleau, la vitesse du produit est égale à la vitesse tangentielle du rouleau, puis elle diminue au fur et à mesure que l'on s'éloigne du rouleau. La décroissance dépend de la rhéologie du produit de remplissage. Dans tous les cas, le rouleau sera disposé à une distance du substrat suffisamment faible pour que l'effet hydrodynamique soit sensible par exemple telle que la vitesse du produit soit supérieure ou égale à cinquante pour cent de la vitesse tangentielle du rouleau au niveau de la zone à remplir. De manière préférentielle, on évitera le contact entre le rouleau et le substrat afin d'une part, de supprimer tout risque de frottement mécanique et d'autre part pour éviter de perturber l'effet hydrodynamique.

Selon l'invention, le remplissage est de préférence assuré à l'aide d'un produit liquide plus ou moins visqueux de zones en creux qui, non débouchantes sur la face opposé du substrat, peuvent aussi être de longueur importante.

Selon une autre caractéristique de la présente invention, le procédé de remplissage consiste à associer un moyen de déplacement en translation du substrat à l'action d'une tête de remplissage prenant appui sur le substrat et contenant le produit de remplissage, ladite tête permettant de générer un différentiel de pression positif entre l'aval et l'amont du moyen de mise en mouvement du produit grâce à l'action conjointe dudit moyen de mise en mouvement du produit de remplissage et d'un élément de raclage formant ainsi une zone aval confinée de surpression totalement occupée par le produit de remplissage et que le moyen de mise en mouvement du produit, constitué de préférence par un rouleau contenu dans la tête de remplissage, provoque une circulation du produit de remplissage au niveau de la zone à remplir dans le sens opposé au déplacement du substrat par rapport à la tête de remplissage formant ainsi une zone amont de moindre pression de manière à évacuer le gaz présent dans les zones à remplir et de le remplacer par du produit de remplissage au fur et à mesure du déplacement du substrat.

Le sens de rotation du rouleau tel que le mouvement tangentiel de celui-ci au niveau de la zone à remplir est opposé au sens de déplacement du substrat, permettra d'une part d'accumuler le produit de remplissage par effet hydrodynamique vers l'élément de raclage de sorte à créer une zone confinée de surpression entre le rouleau et l'élément de raclage situé en aval du rouleau et, d'autre part, de créer une circulation de produit de remplissage au niveau des zones à remplir de la zone de surpression vers la zone de pression moindre située en amont du rouleau.

La surpression créée dans la zone confinée aval sous l'action conjointe de l'élément de mise en mouvement et de l'élément de raclage permet de compenser l'effet de ré-entraînement et de creusement du produit par l'élément de raclage, ré-entraînement appelé effet de traîne. Aussi, une autre caractéristique avantageuse de l'invention consiste à ajuster ou à sélectionner la vitesse de rotation et/ou le diamètre du rouleau de mise en mouvement du produit de remplissage de façon à régler le différentiel de pression de la zone confinée de surpression aval par rapport à la zone de moindre pression amont, permettant ainsi de contrôler le débordement de produit sous l'élément de raclage au niveau des zones à remplir et de compenser l'effet de traîne dudit élément de raclage afin de pouvoir provoquer une surépaisseur du dépôt strictement au droit des zones en creux.

Selon une autre caractéristique de l'invention, afin d'éviter que les bulles extraites par le rouleau formant l'élément de mise en mouvement ne soient ré-entraînées dans la zone à remplir en creux, il peut être judicieux de placer un racleur à la surface du rouleau situé dans la tête de remplissage et de façon idéale tangentiellement sur la partie supérieure du rouleau. Ainsi lors de la rotation du rouleau, les bulles entraînées par le mouvement du produit sont bloquées par ce racleur et n'ont alors pas d'autre alternative que de remonter à la surface du produit de remplissage de par la différence de densité du gaz par rapport au produit. En fait, le racleur à pour but de casser l'effet hydrodynamique, de manière à éliminer localement la mise en mouvement du produit. I1 est à noter que le gaz est aussi naturellement évacué de par la différence de pression existant entre l'aval et l'amont de l'élément de mise en mouvement selon le sens de déplacement du substrat.

Selon une autre caractéristique du procédé selon l'invention, la mise en mouvement du produit peut être réglée. A cet effet, si le dispositif de mise en mouvement du produit de remplissage est constitué d'un rouleau en rotation, la vitesse de rotation de ce rouleau est réglable de façon indépendante de la vitesse de translation du substrat par rapport au dispositif. La vitesse de rotation est ajustée en fonction de la vitesse du substrat par rapport au dispositif, de la rhéologie du produit et de la forme des zones en creux à remplir. Comme cela a été indiqué précédemment, l'effet hydrodynamique peut être plus ou moins amplifié en faisant varier le diamètre et/ou la vitesse de rotation du rouleau. En fait, l'effet hydrodynamique est fonction de la vitesse tangentielle du rouleau. Ainsi, une augmentation du diamètre du rouleau à vitesse de rotation constante génère une augmentation de l'effet hydrodynamique. De la même façon, une augmentation de la vitesse de rotation à diamètre de rouleau constant engendrera également une augmentation de l'effet hydrodynamique. Le couple de paramètres vitesse de rotation et diamètre de rouleau est sélectionné en fonction de la rhéologie du produit de remplissage. En effet, à titre d'exemple, certains produits de remplissage ne supportent pas un cisaillage excessif causé par une vitesse de rotation trop importante. Dans ce cas, on choisira un rouleau de diamètre plus important avec une vitesse de rotation moindre. A titre d'exemple, un diamètre de rouleau de 10 mm associé à une vitesse de rotation de 100 tours par minute donne des résultats de remplissage excellents avec des produite de remplissage disponibles sur le marché à ce jour. La vitesse de déplacement du circuit imprimé ou du substrat par rapport au dispositif de remplissage peut également varier en fonction de l'effet hydrodynamique et de la forme des zones à remplir. Des essais très concluants ont été réalisés avec une vitesse de défilement de 30 mm/s. Enfin, la distance entre le rouleau et la surface du substrat est ajustée en fonction essentiellement de la rhéologie du produit et de la profondeur des zones à remplir. Là encore, des résultats très positifs sont été obtenus avec une distance de 0,5 mm pour des pistes de cuivre de 400 microns (micromètres) d'épaisseur et des produits de remplissage disponibles à ce jour. Evidemment toutes les valeurs évoquées ci-dessus sont données à titre d'exemple ayant occasionné de très bons résultats mais il est possible de les faire varier dans des proportions importantes sans se départir de la présente invention.

L'invention concerne également un dispositif permettant de mettre en oeuvre le procédé de remplissage de la présente invention. Selon l'invention ce dispositif du type sans masque ou écran de sérigraphie de zones situées en creux par rapport à la surface d'un substrat et non débouchantes sur l'autre face du substrat et de longueur pouvant être importante, avec un produit de remplissage liquide plus ou moins visqueux, en translation relativement à la surface du substrat, est remarquable en ce qu'il associe dans l'ordre selon le sens de déplacement relatif du dispositif de remplissage par rapport au substrat :
- un élément d'étalement du produit à remplir à la surface du substrat ,
- un élément de mise en mouvement du produit de remplissage au niveau de la zone à remplir, constitué de préférence par un rouleau en rotation,
- un élément de réglage de l'épaisseur ou de raclage de l'excès de produit de remplissage, de manière à ce que le susdit produit de remplissage reste constamment en contact avec la zone à remplir du début du remplissage jusqu'au raclage de l'excès.

En le concevant de façon symétrique par rapport à l'élément de mise en mouvement du produit de remplissage, ce dispositif peut fonctionner dans les deux sens et être mis en oeuvre sur une machine à sérigraphier. Ainsi, la mise en mouvement du produit de remplissage peut être inversée en fonction du sens d'avance du dispositif par rapport au substrat.

D'autres caractéristiques et avantages apparaîtront plus clairement au vu des figures jointes et de leur description suivante. Les figures représentent des exemples de réalisation non limitatifs de l'invention.
La figure 1 représente en coupe un dispositif de remplissage selon la présente invention.
La figure 2 représente de façon schématique un moyen de translation associé au dispositif de remplissage de la figure 1.
La figure 3 représente en coupe un remplissage de substrat effectué selon la présente invention.
La figure 4 montre en vue de dessus une photographie d'un substrat à remplir.
La figure 5 montre un détail agrandi d'un substrat à remplir.
La figure 6 montre une tête de remplissage équipée d'un racleur de l'élément de mise en mouvement.
Les figures 7, 8, 9 et 10 sont des vues en perspective illustrant les différentes phases d'un mode de réalisation d'un équipement associé au dispositif de remplissage de la figure 1.
Les figures 11a, 11b et 11c sont des vues de face, de côté et de dessus respectivement d'un mode réalisation complet de l'équipement de la figure 7.

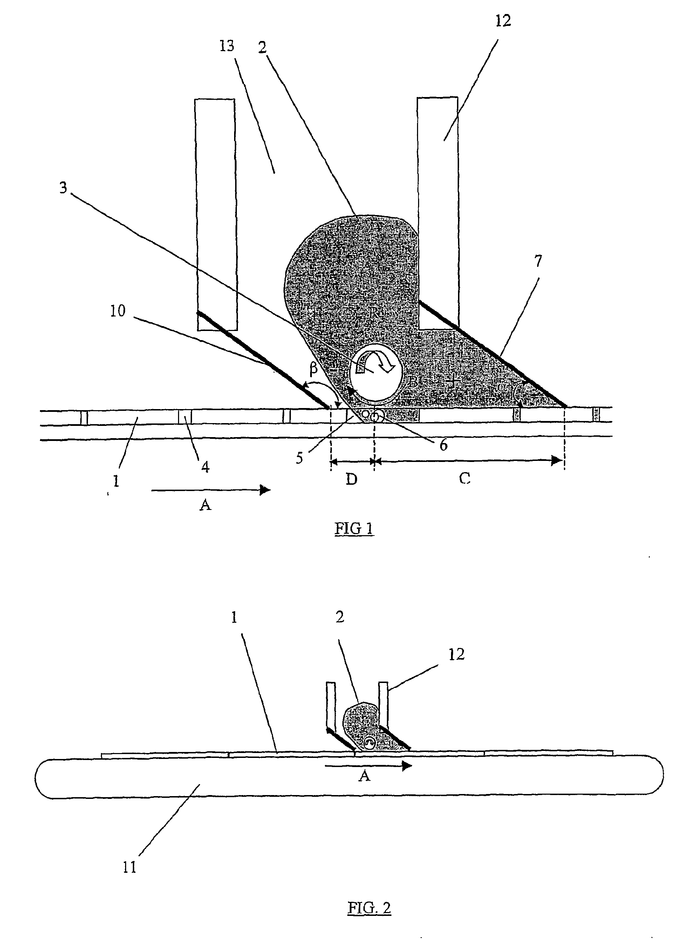

Les figures 1 et 2 représentent schématiquement et en coupe:
- une tête de remplissage 12 ,
- et un moyen de déplacement en translation 11 d'un substrat 1, constitué ici par un circuit imprimé, permettant un défilement en continu (flèche A) de celui-ci au-dessous de la susdite tête de remplissage 12.

Bien que le mouvement de translation relatif de la tête de remplissage 12 par rapport au substrat 1 puisse être obtenu par le déplacement de la tête 12 en maintenant le substrat 1 fixe c'est la solution de maintenir la tête 12 fixe et le substrat 1 mobile qui a été adoptée car plus facile à mettre en oeuvre.

La tête de remplissage 12, réalisée conformément aux dispositions principales de la présente invention, comprend :
- une chambre 13 contenant le produit de remplissage 2, ladite chambre 13 étant délimitée en aval par une racle 7 inclinée d'un angle α inférieur ou égal à 90° et en amont d'une racle 10 inclinée dans le même sens d'un angle β égal ou supérieur à 90°
- et un rouleau 3 de mise en mouvement du produit 2 placé entre les racles 7 et 10 et tournant dans le sens tel que le mouvement tangentiel du rouleau 3 au niveau des zones en creux à remplir 4 est opposé au mouvement de translation A du substrat 1 par rapport à la tête de remplissage 12.

La rotation R du rouleau 3 provoque un déplacement du produit 2 au niveau des zones à remplir 4 au fur et à mesure qu'elles se présentent sous le rouleau 3, ce dernier tournant dans le sens B qui est opposé au sens de déplacement A du substrat 1 par rapport à la tête de remplissage 12. L'action conjointe du rouleau 3 et de l'élément de raclage 7 génère alors une zone confinée aval C de surpression dans le produit 2 situé entre ces deux derniers éléments. En effet, le rouleau 3 génère un effet hydrodynamique et pousse le produit 2 contre l'élément de raclage 7 qui est une paroi inclinée d'un angle α inférieur à 90° mesuré entre le substrat 1 et la paroi de l'élément de raclage 7. Il est particulièrement judicieux d'effectuer ce raclage à l'aide d'une paroi 7 inclinée dont l'angle d'inclinaison peut être adapté en fonction de la rhéologie du produit 2 et de la vitesse d'avance A du substrat 1 par rapport à la tête de remplissage 12. Ainsi plus l'angle α sera faible et plus la surpression dans la zone confinée C entre le rouleau 3 et l'élément de raclage sera importante. L'angle α de l'élément de raclage aval 7 du surplus de produit 2 est aussi adapté de manière à limiter l'effet de ré-entraînement ou de traîne de produit à l'arrière dudit élément de raclage 7.

Il en résulte alors que l'air 5 présent dans les zones en creux 4 est évacué par déplacement ou sous forme de bulles 6 et est remplacé par du produit 2. Si l'air est évacué sous forme de bulles 6, ces dernières sont chassées du produit 2 grâce au différentiel de pression régnant entre la zone aval confinée C et la zone amont D du rouleau 3. La paroi de l'élément amont 10 permet de contenir le produit 2 dans un volume fermé 13 et est inclinée dans le même sens que la paroi de l'élément aval 7 et forme un angle β supérieur à 90° avec le substrat 1. De préférence, la tête de remplissage 12 sera fermée en prévoyant la possibilité de provoquer un certain niveau de vide dans la partie de la tête 12 de manière à ce que la dépression provoquée favorise l'évacuation de l'air extrait des zones à remplir 4. De même, il pourra être prévu d'équiper la tête de remplissage 12 :
- d'un système de fixation rapide pour le passage d'une tête 12 à une autre,
- d'un élément d'obturation de sa partie inférieure afin d'éviter que le produit 2 contenu dans la tête 12 ne s'écoule lors d'un arrêt de production ou lors d'un changement de tête,
- d'un réglage en longueur pour qu'elle s'adapte à la largeur du substrat 1 de façon à reconfigurer rapidement le dispositif de l'invention en fonction de la largeur du circuit imprimé 1 à traiter,
- etc...

Il est impératif aussi que le produit de remplissage 2 soit présent en quantité suffisante pour occuper tout l'espace confiné entre le rouleau 3 et l'élément de raclage 7. Cette condition est nécessaire pour assurer la mise en pression du produit 2. Il est donc envisageable de prévoir un dispositif de maintien d'un volume minimum de produit 2 dans la tête de remplissage 12. Ainsi, il est recommandé de remplir la tête de remplissage 12 avec un volume minimum de produit de telle sorte que le rouleau 3 formant l'élément de mise en mouvement du produit 2 soit toujours entièrement recouvert à l'état de repos.

Afin d'accentuer la mise en mouvement du produit de remplissage 2, il peut être judicieux de modifier l'état de surface du rouleau 3, par exemple en le striant avec des rayures parallèles à l'axe du rouleau ou de pourvoir le rouleau 3 avec des ailettes souples ou rigides toujours parallèles à l'axe du rouleau.

Le dessin de la figure 2, représente schématiquement un mode de réalisation d'un convoyeur Il assurant le déplacement des substrats à remplir 1 qui défilent au-dessous de La tête de remplissage 12, dans le sens A. Il va de soi que le convoyeur 11 représenté ici formé d'un tapis roulant pourrait être remplacé par un cylindre d'entraînement ou tout autre dispositif permettant l'avancement A du circuit 1 au-dessous de La tête de remplissage 12.

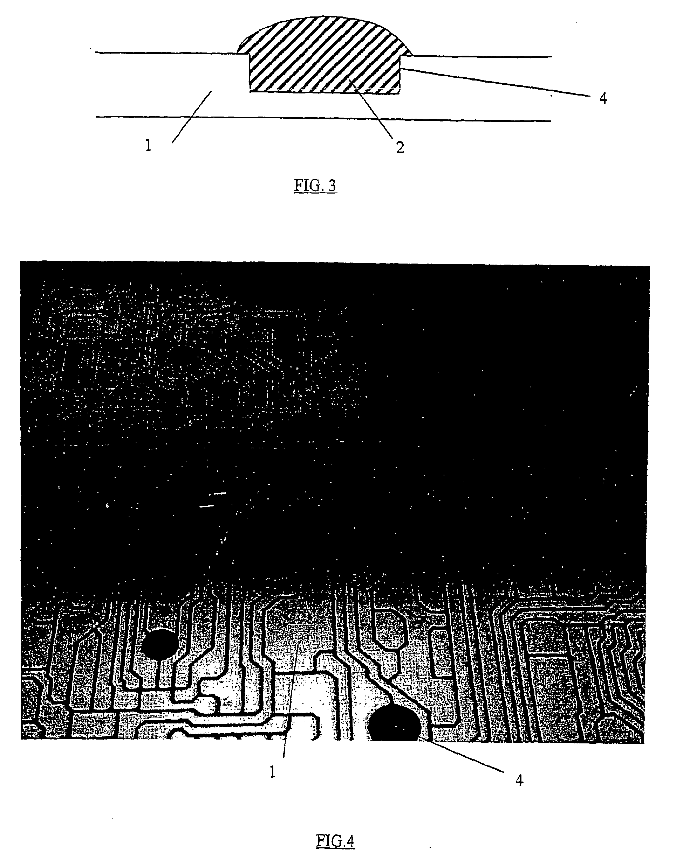

La figure 3 est une coupe d'un substrat 1 dont la zone en creux 4 a été remplie par du produit 2 selon le procédé de la présente invention. Comme on peut le voir, le remplissage de la zone 4 est tel que le produit 2 est légèrement en surépaisseur par rapport au substrat 1. Ceci est particulièrement intéressant car on est ainsi certain d'un remplissage complet et sans creusement des zones 4. Ceci est rendu possible grâce à la zone confinée de surpression provoquée sous l'action conjointe de l'élément de mise en mouvement 3 et de l'élément de raclage aval 7. En effet, la surpression C va créer un léger débordement sous l'élément de raclage aval 7 dans la zone à remplir 4. Ce débordement va compenser l'effet de traîne de la racle et provoquer une surépaisseur strictement au dessus des zones en creux 4.

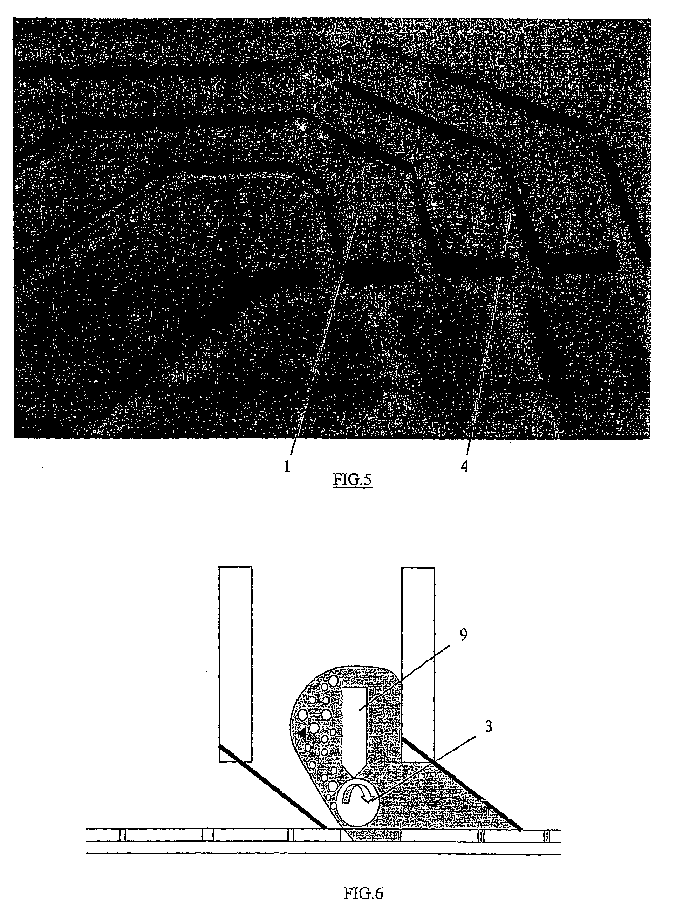

Sur la photographie de la figure 4 montrant un substrat 1 à remplir, on peut voir que les zones en creux 4 sont formées par des zones inter-pistes qui peuvent s'étendre sur plusieurs centimètres. Le but de l'invention est de remplir de façon complète et sans bulles, les zones 4 par un produit diélectrique. La difficulté de remplissage vient du fait que les zones 4 sont non débouchantes sur la face opposée et que par conséquent de l'air reste prisonnier dans certaines zones. Pour remplir ces zones, il ne suffit pas d'augmenter la pression sur le produit, car ceci a uniquement pour effet de comprimer l'air piégé dans les zones en creux 4 lors du passage de la tête de remplissage 12. Pour effectuer ce remplissage, la présente invention propose donc de générer un flux de produit 2 au niveau des zones à remplir 4 de manière à entraîner l'air 5 présent dans les zones en creux 4 par déplacement ou sous forme de bulles 6 et de le remplacer au fur et à mesure par du produit de remplissage 2.

Sur la photographie de la figure 5 montrant un détail d'un substrat à remplir 1, on peut apprécier la profondeur des zones à remplir 4 qui ici est d'environ 400 microns (micromètres). Les pistes conductrices sont en cuivre.

La figure 6 représente schématiquement en coupe une tête de remplissage équipée d'un racleur 9 disposé tangentiellement sur la partie supérieure du rouleau 3 afin de casser l'effet hydrodynamique de façon à éliminer localement la mise en mouvement du produit 2 et provoquer l'évacuation des bulles d'air 6 par blocage sur la paroi du racleur 9 et favorisant ainsi l'évacuation vers la surface.

Dans le cas où les substrats 1 sont constitués par des circuits imprimés présentant de fortes épaisseurs de cuivre, les surépaisseurs de produit 2 seront aisément supprimées lors d'un brossage intervenant après la polymérisation du produit 2.

Le procédé de remplissage de l'invention peut fonctionner de manière autonome, par exemple avec une rotation R du rouleau à effet hydrodynamique 3 générée par un moto-variateur électrique, et avec un mouvement de translation A du substrat 1 par rapport à la tête de remplissage 12 assuré soit manuellement soit par un dispositif automatique d'entraînement comme un convoyeur, un tapis roulant ou un rouleau d'entraînement.

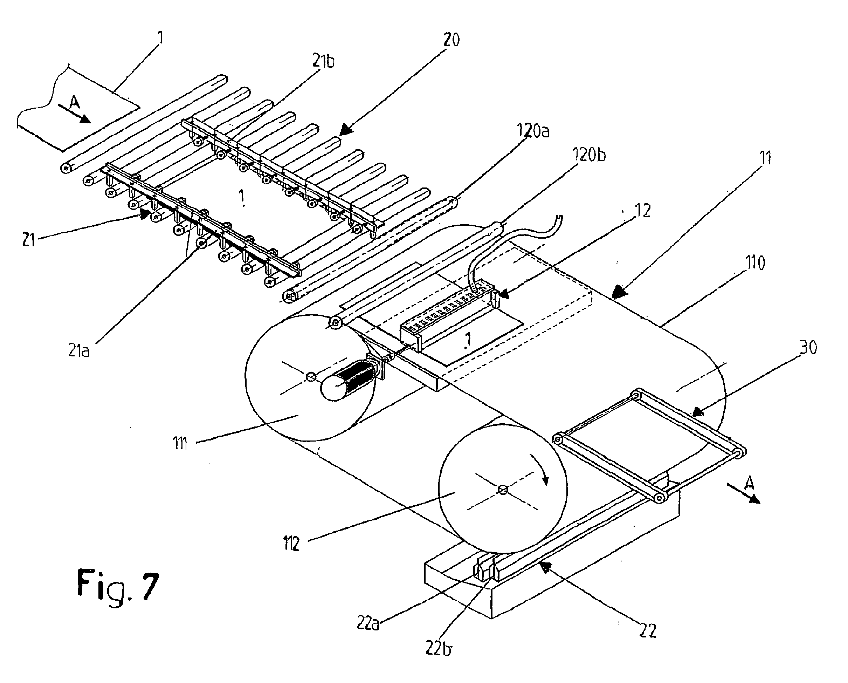

Le dessin de la figure 7 a pour objet d'illustrer un mode de réalisation d'un exemple d'équipement associé à une tête de remplissage 12 pour assurer le remplissage de zones en creux 4 de substrats 1.

Comme on peut le voir, cet équipement se compose .
- du convoyeur 11 qui assure la translation A des substrats 1 au-dessous de la tête de remplissage 12,
- d'un convoyeur d'alimentation 20 situé en amont du convoyeur 11 dans le sens d'avancement A pour acheminer les substrats à remplir 1 vers le convoyeur 11 au-dessous de la tête de remplissage 12,
- et d'un convoyeur d'évacuation 30 situé en aval du convoyeur 11 pour récupérer les substrats 1 venant d'être remplis par la tête de remplissage 12.

Selon l'invention, le convoyeur 11 est plus précisément constitué par un tapis sans fin 110 réalisé de préférence en acier inoxydable et qui, entraîné autour de deux cylindres 111 et 112 dont un au moins est moteur, est associé en entrée à deux cylindres presseurs 120a et 120b disposés au-dessus du tapis 110 de manière à maintenir en pression et à entraîner sur le tapis 110 au-dessous de la tête de remplissage 12, les substrats 1 venant de sortir du convoyeur d'admission 20.

Le convoyeur d'alimentation 20 du type à rouleaux comporte un dispositif de centrage 21 formé de deux rails de guidage 21a et 21b bordés intérieurement de galets de roulement et qui, montés réglables en largeur, permettent de positionner convenablement les substrats 1 avant leur admission au-dessous de la tête de remplissage 12 sur le convoyeur 11. Comme le convoyeur Il sera immanquablement pollué par du produit 2, il a été disposé au-dessous du tapis 110, un dispositif de nettoyage en continu 22 du tapis sans fin 110 constitué d'une ou plusieurs lames former des racles (deux 22a et 22b étant représentées) en appui sur la face externe du tapis 110 au-dessous du convoyeur 11. Ce dispositif de nettoyage peut aussi être remplacé par un applicateur de solvant.

Le convoyeur d'évacuation 30 du type à courroies permet d'acheminer les substrats 1 venant d'être remplis par la tête 12 vers une autre unité de traitement.

Le fonctionnement de l'équipement permettant de remplir des circuits 1 de produit 2 contenu dans la tête de remplissage 12, tel qu'il vient d'être ci-dessus décrit est simple et le suivant en référence aux figures 7, 8, 9 et 10.

Dans un premier temps illustré par le dessin de la figure 7, un circuit 1 est disposé au-dessous de la tête de remplissage 12 pendant qu'un autre circuit 1 est guidé entre les deux rails 21a et 21b du dispositif de centrage 21 du convoyeur d'admission 20.

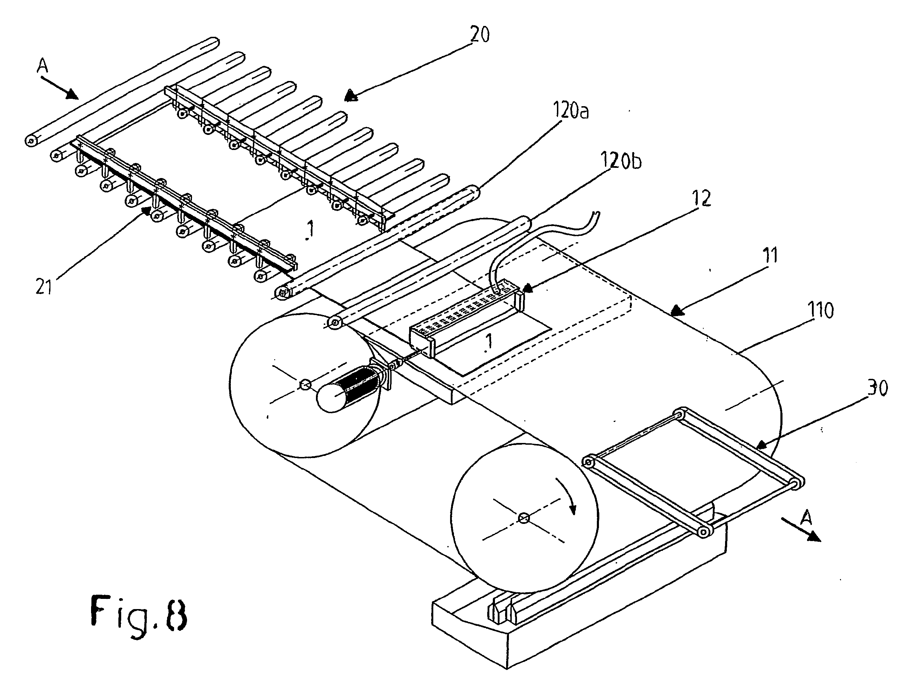

Dans un deuxième temps illustré par le dessin de la figure 8, le circuit 1 venant d'être centré sur le convoyeur 20 est entraîné par les rouleaux presseurs 120a et 120b du convoyeur 11 pour venir en contact avec le circuit 1 disposé au-dessous de la tête de remplissage 12 et qui défile dans le sens de la flèche A de manière à faire remplir ses zones en creux 4 par la tête de remplissage 12 selon le procédé de l'invention.

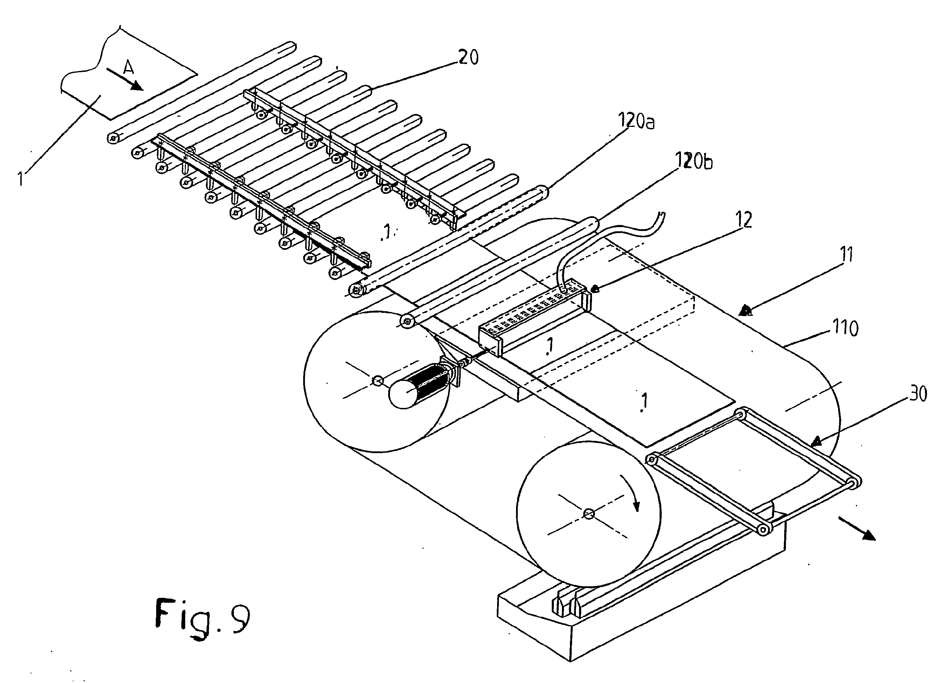

Dans un troisième temps illustré par le dessin de la figure 9, le circuit 1 qui était au-dessous de la tête de remplissage 12 sort complètement de cette dernière poussé par les précédents et via le tapis sans fin 110, avec du produit 2 appliqué par la tête 12.

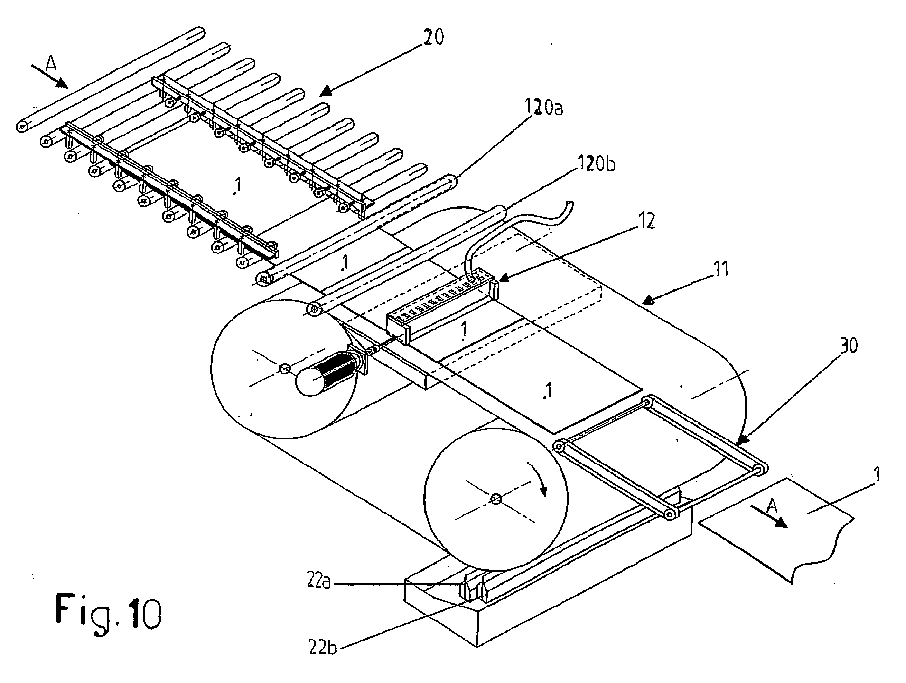

Dans un quatrième temps illustré par le dessin de la figure 10, le circuit 1 est transféré du convoyeur 11 vers le convoyeur à courroie 30 à des fins d'acheminement vers une autre unité de traitement ou de stockage. Le produit de remplissage 2 restant sur le tapis 110 du convoyeur 11 est ensuite enlevé et nettoyé par les lames 22a et 22b du dispositif 22.

Ainsi donc, le dispositif selon l'invention permet de faire défiler les circuits 1 de manière continue sous la tête de remplissage 12. En effet, grâce à l'action conjointe du convoyeur 20 et des rouleaux presseurs 120a et 120b, les circuits 1 sont en contact les uns avec les autres pendant le passage sous la tête 12. Ce contact permet de minimiser la pollution du tapis 110 par du produit 2.

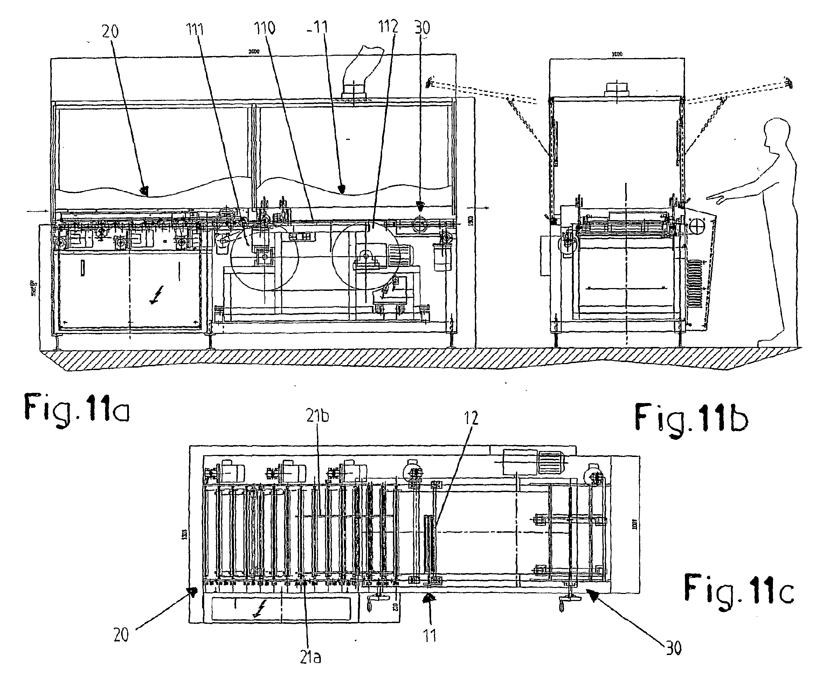

Les dessins des figures 11a, 11b et 11c montrent en vues de face, de côté et de dessus respectivement un mode réalisation complet d'un tel équipement montrant la structure logique du bâti-support et les organes d'entraînement nécessaires au fonctionnement :
- du convoyeur 11 avec son tapis sans fin 110 entraîné autour des deux cylindres 111 et 112 pour assurer la translation A des substrats 1 au-dessous de la tête de remplissage 12,
- du convoyeur d'alimentation à rouleaux 20 avec les deux rails de guidage 21a et 21b de son dispositif de centrage 21 et qui, situé en amont du convoyeur 11 dans le sens d'avancement A, achemine les substrats à remplir 1 vers le convoyeur 11 au-dessous de la tête de remplissage 12,
- et du convoyeur d'évacuation 30 du type à courroies et qui, situé en aval du convoyeur 11, pour récupère les substrats 1 venant d'être remplis par la tête de remplissage 12.

On notera que les convoyeurs d'alimentation amont 20 et aval 30 sont réglables manuellement en position par rapport au convoyeur central 11.

## Revendications

1. Procédé de remplissage direct sans bulle d'air et en surépaisseur d'interpistes ou de zones (4) situées en creux par rapport à la surface d'un substrat ou d'un circuit imprimé (1) et non débouchantes sur l'autre face par un produit visqueux (2), **CARACTERISE EN CE QU'**il consiste :
- à mettre en mouvement le produit de remplissage (2) au niveau des zones à remplir (4) par l'effet hydrodynamique d'un rouleau en rotation (3) dont l'axe est perpendiculaire au mouvement du substrat par rapport au dispositif et parallèle au substrat et à générer un différentiel de pression entre l'aval et l'amont du rouleau, grâce à l'action conjointe du rouleau (3) et d'un élément de raclage (7) de manière à évacuer sous forme de bulles (6) le gaz (5) présent dans les zones en creux (4) et de le substituer par du produit de remplissage (2)
- et à régler l'épaisseur de produit (2) à la surface du substrat (1)par l'élément de raclage (7).

2. Procédé de remplissage selon la revendication 1, **CARACTERISE EN CE QU'**il consiste successivement :
- à rendre étanche la zone à remplir (4) à toute entrée de gaz extérieur à la zone (4), en étalant le produit (2) à la surface du substrat (1) de manière à isoler les zones à remplir (4) du gaz extérieur et de mettre le produit (2) à disposition,
- à mettre le produit (2) en mouvement au niveau des zones à remplir (4) de manière à évacuer sous forme de bulles (6) le gaz (5) présent dans les zones à remplir (4) sous le produit de remplissage (2),
- à substituer le gaz (5) évacué sous forme de bulles (6), par du produit de remplissage (2),
- et à régler l'épaisseur de produit (2) à la surface du substrat (1).

3. Procédé de remplissage selon la revendication 1, **CARACTERISE EN CE QUE** la mise en mouvement du produit (2) au niveau de la zone à remplir (4) est obtenue par un effet hydrodynamique.

4. Procédé de remplissage selon la revendication 1, **CARACTERISE EN CE QU'**il consiste à bloquer les bulles de gaz (6) extraites par le moyen de mise en mouvement (3) du produit de remplissage (2), au moyen d'un racleur (9) afin qu'elles ne soient pas ré-entraînées dans les zones à remplir (4).

5. Procédé de remplissage selon la revendication 1, **CARACTERISE EN CE QUE** lesdites zones à remplir (4) sont non débouchantes sur l'autre face du substrat (1) et de grande longueur, de plusieurs millimètres à plusieurs décimètres et pouvant présenter un ratio d'aspect défini par la profondeur de la zone relativement à la surface divisée par la plus petite dimension d'ouverture, inférieur à 1.

6. Procédé de remplissage selon la revendication 1, **CARACTERISE EN CE QUE** la vitesse du mouvement du produit de remplissage (2) est réglable.

7. Procédé de remplissage selon la revendication 1, **CARACTERISE EN CE QUE** la mise en mouvement du produit de remplissage (2) au niveau de la zone à remplir (4) est obtenue par un effet hydrodynamique d'un rouleau en rotation (3) dont l'axe est perpendiculaire au mouvement du substrat par rapport au dispositif et parallèle au substrat et selon le sens tel que le mouvement tangentiel du rouleau au niveau de la zone à remplir est opposé au sens de déplacement du substrat (1).

8. Procédé de remplissage selon la revendication 1, **CARACTERISE EN CE QU'**il associe un moyen de déplacement (11) en translation du substrat (1) à l'action d'une tête de remplissage (12) prenant appui sur le substrat (1) et contenant le produit de remplissage (2), ladite tête (12) permettant de générer un différentiel de pression positif entre l'aval et l'amont du moyen de mise en mouvement (3) du produit (2) grâce à l'action conjointe dudit moyen de mise en mouvement (3) du produit de remplissage (2) et d'un élément de raclage (7) formant ainsi une zone aval confinée de surpression (C) totalement occupée par le produit de remplissage et que le moyen de mise en mouvement (3) provoque une circulation du produit de remplissage au niveau de la zone à remplir dans le sens opposé au déplacement du substrat par rapport à la tête de remplissage (12) formant ainsi une zone amont de moindre pression (D) de manière à évacuer le gaz (5) présent dans les zones à remplir (4) et de le remplacer par du produit de remplissage (2) au fur et à mesure du déplacement du substrat (1).

9. Procédé de remplissage selon les revendications 1, 7 et 8, **CARACTERISE EN CE QUE** le rouleau (3) assurant la mise en mouvement du produit de remplissage (2) est contenu dans la susdite tête de remplissage (12).

10. Procédé de remplissage selon les revendications 8 et 9, **CARACTERISE EN CE QUE** la vitesse de rotation et/ou le diamètre du susdit rouleau (3) contenu dans la tête de remplissage (12) sont ajustables de façon à régler le différentiel de pression de la zone confinée de surpression (C) par rapport à la zone de moindre pression (D) permettant de contrôler le débordement de produit (2) sous l'élément de raclage aval (7) au niveau des zones à remplir (4) et de compenser l'effet de traîne dudit élément de raclage aval (7).

11. Dispositif de remplissage sans masque ou écran de sérigraphie de zones situées en creux (4) par rapport à la surface d'un substrat (1) et non débouchantes sur l'autre face du substrat (1) et pouvant s'étendre sur une grande longueur, de plusieurs millimètres à plusieurs décimètres et pouvant présenter un ratio d'aspect défini par la profondeur de la zone relativement à la surface divisée par la plus petite dimension d'ouverture,, inférieur à 1, avec un produit de remplissage visqueux (2), en translation relativement à la surface du substrat (1) et mettant en oeuvre le procédé de remplissage selon l'une quelconque des revendications 1 à 11, **CARACTERISE PAR LE FAIT QU'**il associe dans l'ordre selon le sens de déplacement relatif du dispositif de remplissage par rapport au substrat (1) :
- un élément d'étalement (10) du produit à remplir (2) à la surface du substrat (1),
- un élément de mise en mouvement (3) du produit de remplissage (2) au niveau de la zone à remplir (4), obtenu par l'effet hydrodynamique d'un rouleau en rotation (3) dont l'axe est perpendiculaire au mouvement du substrat par rapport au dispositif et parallèle au substrat et à générer un différentiel de pression entre l'aval et l'amont du rouleau, grâce à l'action conjointe du rouleau (3) et d'un élément de raclage (7) de manière à évacuer sous forme de bulles (6) le gaz (5) présent dans les zones en creux (4) et de le substituer par du produit de remplissage (2),
- un élément (7) de réglage de l'épaisseur ou de raclage de l'excès de produit de remplissage (2),
de manière à ce que le susdit produit de remplissage (2) reste constamment en contact avec la zone à remplir (4) du début du remplissage jusqu'au raclage de l'excès.

12. Dispositif de remplissage selon la revendication 11, **CARACTERISE PAR LE FAIT QUE** l'élément de mise en mouvement (3) est constitué par un rouleau en rotation (3) .

13. Dispositif de remplissage selon la revendication 11, **CARACTERISE PAR LE FAIT QUE** le dispositif est symétrique de manière à pouvoir fonctionner dans les deux sens et être mis en oeuvre sur une machine à sérigraphier.

14. Dispositif de remplissage selon la revendication **11. CARACTERISE PAR LE FAIT QUE ledit mouvement de** translation relatif du produit de remplissage (2) relativement à la surface du substrat (1) est obtenu en maintenant le dispositif de remplissage de produit (2) fixe alors que le substrat (1) est mobile.

15. Dispositif de remplissage selon les revendications 11 et 12, **CARACTERISE PAR LE FAIT QU'**il comprend un racleur (9) destiné à bloquer les bulles (6) extraites par le susdit élément de mise en mouvement (3).

16. Dispositif de remplissage selon l'une quelconque des revendications 11 à 15, **CARACTERISE PAR LE FAIT QU'**il se compose :
- d'une tête de remplissage (12) comprenant :
a) une chambre (13) contenant le produit de remplissage (2), ladite chambre (13) étant délimitée en aval par une racle (7) inclinée d'un angle α inférieur ou égal à 90° et en amont d'une racle (10) inclinée dans le même sens d'un angle β égal ou supérieur à 90°
b) un rouleau (3) de mise en mouvement du produit (2) placé entre les racles (7) et (10) et tournant dans le sens tel que le mouvement tangentiel du rouleau (3) au niveau de la zone à remplir est opposé au mouvement de translation (flèche A) du substrat par rapport au dispositif de remplissage.
- et d'un moyen de déplacement en translation (11) du substrat (1) permettant un défilement en continu (flèche A) de celui-ci au-dessous de la susdite tête de remplissage (12).

17. Dispositif de remplissage selon la revendication 16, **CARACTERISE PAR LE FAIT QUE** le susdit moyen de déplacement en translation (11) du substrat (1) est un tapis roulant.

18. Dispositif de remplissage selon la revendication 16, **CARACTERISE PAR LE FAIT QUE** la susdite tête de remplissage (12) est équipée d'un élément d'obturation disposé dans sa partie inférieure.

19. Dispositif de remplissage selon la revendication 16, **CARACTERISE PAR LE FAIT QUE** la susdite tête de remplissage (12) est réglable en longueur en fonction de la largeur du substrat (1) à traiter.

20. Dispositif de remplissage selon la revendication 16, **CARACTERISE PAR LE FAIT QUE** la susdite tête de remplissage (12) est adaptée à la largeur du substrat (1) à traiter et qu'un système de fixation rapide permet le passage d'une tête de remplissage à une autre.

21. Dispositif de remplissage selon la revendication 16, **CARACTERISE PAR LE FAIT QUE** le susdit rouleau (3) comporte des ailettes parallèles à l'axe du rouleau de manière à accentuer la mise en mouvement du produit de remplissage (2).

22. Dispositif de remplissage selon les revendications 15 et 16, **CARACTERISE PAR LE FAIT QUE** le susdit racleur (9) est placé tangentiellement sur la partie supérieure de l'élément de mise en mouvement (3) de façon à provoquer l'évacuation des bulles d'air (6).

23. Dispositif de remplissage selon l'une quelconque des revendications 12 à 22, **CARACTERISE PAR LE FAIT QUE** le susdit substrat (1) est un circuit imprimé.

24. Dispositif de remplissage selon l'une quelconque des revendications 12 à 23, **CARACTERISE PAR LE FAIT QUE** la susdite tête de remplissage (12) contenant le produit de remplissage (2) est fermée.

25. Dispositif de remplissage selon l'une quelconque des revendications 12 à 23, **CARACTERISE PAR LE FAIT QUE** la susdite tête de remplissage (12) contenant le produit de remplissage (2) est fermée avec création d'un niveau de vide dans sa partie située au-dessus du produit de remplissage (2) pour favoriser l'évacuation de l'air extrait des zones à remplir (4)des substrats (1).

26. Equipement associé à un dispositif de remplissage selon l'une quelconque des revendications 12 à 25, **CARACTERISE PAR LE FAIT QU'**il se compose :
- du convoyeur (11) qui assure la translation A des substrats (1) au-dessous de la tête de remplissage (12),
- d'un convoyeur d'alimentation (20) situé en amont du convoyeur (11) pour acheminer les substrats à remplir (1) vers le convoyeur (11) au-dessous de la tête de remplissage (12),
- et d'un convoyeur d'évacuation (30) situé en aval du convoyeur (11) pour récupérer les substrats (1) venant d'être remplis par la susdite tête de remplissage (12).

27. Equipement selon la revendication 26, **CARACTERISE PAR LE FAIT QUE** le convoyeur (11) est constitué par un tapis roulant sans fin (110) qui, entraîné autour de deux cylindres (111 et 112) dont un au moins est moteur, est associé en entrée à au moins un cylindre presseur (120a ou 120b) disposé au-dessus du tapis (110) de manière à maintenir en pression et à entraîner sur le tapis (110) au-dessous de la tête de remplissage (12), le substrat (1) venant de sortir du convoyeur d'admission (20).

28. Equipement selon la revendication 26, **CARACTERISE PAR LE FAIT QUE** le convoyeur, d'alimentation (20) est du type à rouleaux et comporte un dispositif de centrage (21) formé de deux rails de guidage (21a et 21b) bordés intérieurement de galets de roulement et qui, montés réglables en largeur, permettent de positionner convenablement les substrats (1) avant leur admission au-dessous de la tête de remplissage (12) sur le convoyeur (11).

29. Equipement selon la revendication 26, **CARACTERISE PAR LE FAIT Qu'**il comprend un dispositif de nettoyage en continu (22) du tapis sans fin (110) qui, constitué d'au moins une lame (22a ou 22b), est disposé en appui sur la face externe du tapis (110) au-dessous du convoyeur (11) pour former des racles.

30. Equipement selon la revendication 26, **CARACTERISE PAR LE FAIT QUE** le convoyeur d'évacuation (30) est du type à courroies et permet d'acheminer les substrats (1) venant d'être remplis par la tête (12) vers une autre unité de traitement.

## Claims

1. A method of direct filling without air bubbles and overlaying intertracks or zones (4) in hollows with respect to the surface of a substrate or of a printed circuit (1)and closed on the other face by a viscous product (2), **characterized in that** it comprises:
- displacing the filling product (2) at the point of zones to be filled (4)by the hydrodynamic effect of a roller in rotation (3) of which the axis is perpendicular to the movement of the substrate with respect to the device and parallel to the substrate and generating a pressure differential between the downstream and upstream of the roller, with the aid of the concerted action of the roller (3) and of a scraping element (7) in order to evacuate in the form of bubbles (6) the gas (5) present in the zones in hollows (4) and to substitute it by filling product (2)
- and adjusting the thickness of the product (2) at the surface of the substrate (1)by the scraping element (7) .

2. The method of filling according to claim 1, **characterized in that** it comprises successively:
- making the zone to be filled (4) impermeable to all entry of gas exterior to the zone (4), by spreading the product (2) at the surface of the substrate (1) in order to isolate the zones to be filled (4) from the exterior gas and to make the product (2) available.
- displacing the product (2) at the point of zones to be filled in order to evacuate, in the form of bubbles (6), the gas (5) present in the zones to be filled (4) under the filling product (2),
- substituting the gas (5) evacuated in the form of bubbles (6), by the filling product (2),
- and adjusting the thickness of the product (2) at the surface of the substrate (1).

3. The method of filling according to claim 1, **characterized in that** the displacing of the product (2) at the point of the area to be filled (4) is obtained by a hydrodynamic effect.

4. The method of filling according to claim 1, **characterized in that** it comprises blocking the gas bubbles (6) extracted by the displacing means (3) of the filling product (2), with the scrapping means (9) so that they are not re-drawn in the zones to be filled (4).

5. The method of filling according to claim 1, **characterized in that** the aforementioned zones to be filled (4) are closed on the other face of the substrate (1) and have a long length, of several millimeters to several decimeters and possibly presenting an aspect ratio, defined by the depth of the zone relative to the surface divided by the smallest aperture dimension, less than one.

6. The method of filling according to claim 1, **characterized in that** the speed of movement of the filling product (2) is adjustable.

7. The method of filling according to claim 1, **characterized in that** the displacing of the filling product (2) at the point of the zone to be filled (4) is obtained by a hydrodynamic effect of a roller in rotation (3) of which the axis is perpendicular to the movement of the substrate with respect to the device and parallel to the substrate and according to the direction such that the tangential movement of the roller at the point of the zone to be filled is opposed to the direction of displacement of the substrate (1).

8. The method of filling according to claim 1, **characterized in that** it associates a means for displacement (11) in translation of the substrate (1) to the action of a filling head (12) resting on the substrate (1) and containing the filling product (2), the aforementioned head (12) permitting the generation of a positive pressure differential between the downstream and upstream of the means for displacing (3) of the product (2) due to the concerted action of the aforementioned means for displacing (3) of the filling product (2) and a scraping element (7) forming in this manner a confined downstream zone of surge pressure (C) totally occupied by the filling product and the means for displacing (3) causes a circulation of the filling product at the point of the zone to be filled in the direction opposed to the displacement of the substrate with respect to the filling head (12) forming in this manner an upstream zone of reduced pressure (D) in order to evacuate the gas (5) present in the zones to be filled (4) and to replace it by filling product (2) as the substrate (1) is displaced.

9. The method of filling according to claims 1, 7 and 8, **characterized in that** the roller (3) assuring the displacement of the filling product (2) is contained in the above-mentioned filling head (12).

10. The method of filling according to claims 8 and 9, **characterized in that** the speed of rotation and/or the diameter of the above-mentioned roller (3) contained in the filling head (12) are adjustable in order to adjust the pressure differential of the confined zone of surge pressure (C) with respect to the zone of reduced pressure (D) permitting control of the running of the product (2) under the scrapping element downstream (7) at the point of the zones to be filled (4) and to compensate for the trailing effect of the aforementioned scrapping element downstream (7).

11. A filling device without mask or silk screen for zones located in hollows (4) with respect to the surface of the substrate (1) and closed on the other face of the substrate (1) and possibly extending a long length, of several millimeters to several decimeters and possibly presenting an aspect ratio, defined by the depth of the zone relative to the surface divided by the smallest aperture dimension, less than one, with a viscous liquid filling product (2), in translation relative to the surface of the substrate (1) and implementing the filling method according to any one of claims 1 to 11, **characterized by** the fact that it associates in the order according to the direction of relative displacement of the filling device with respect to the substrate (1) :
- a spreading element (10) for the filling product (2) at the surface of the substrate (1),
- a displacing element (3) for the filling product (2) at the point of the zone to be filled (4), obtained by a hydrodynamic effect of a roller in rotation (3) of which the axis is perpendicular to the movement of the substrate with respect to the device and parallel to the substrate and generating a pressure differential between the downstream and upstream of the roller, with the aid of the concerted action of the roller (3) and of a scraping element (7) in order to evacuate in the form of bubbles (6) the gas (5) present in the zones in hollows (4) and to substitute it by filling product (2),
- an element (7) for adjusting the thickness or scraping the excess of the filling product (2), in a manner such that the above-mentioned filling product (2) remains constantly in contact with the zone to be filled (4) from the beginning of the filling up to the scraping of the excess.

12. The filling device according to claim 11, **characterized by** the fact that displacing element (3) is constituted by a roller in rotation (3).

13. The filling device according to claim 11, **characterized by** the fact that the device is symmetric in order to be able to operate in the two directions and to be implemented on a silk screen machine.

14. The filling device according to claim 11, **characterized by** the fact that the aforementioned relative movement in translation of the filling product (2) relative to the surface of the substrate (1) is obtained by maintaining the filling device for the product (2) fixed while the substrate (1) is moving.

15. The filling device according to claims 11 and 12, **characterized by** the fact that it comprises a scraper (9) for blocking the bubbles (6) extracted by the above-mentioned displacing element (3).

16. The filling device according to any one of the claims 11 to 15, **characterized by** the fact that it is composed :
- of a filling head (12) comprising :
a) a chamber (13) containing the filling product (2), the aforementioned chamber (13) being delimited downstream by a scraper (7) inclined at an angle a less than or equal to 90° and upstream by a scraper (10) inclined in the same direction at an angle b equal to or greater than 90°
b) a roller (3) placed between the scrapers (7) and (10) for displacing of the product (2) and turning in the direction such that the tangential movement of the roller (3) at the point of the zones to be filled is opposed to the movement in translation (arrow A) of the substrate with respect to the filling device.
- and a means for displacement in translation (11) of the substrate (1), permitting a continuous running (arrow A) of it under the above-mentioned filling head (12).

17. The filling device according to claim 16, **characterized by** the fact that the above-mentioned means for displacing in translation (11) of the substrate (1) is a conveyor belt.

18. The filling device according to claim (16), **characterized by** the fact that the above-mentioned filling head (12) is equipped with a sealing element arranged in its lower part.

19. The filling device according to claim 16, **characterized by** the fact that the above-mentioned filling head (12) is adjustable in length according to the width of the substrate (1) to be treated.

20. The filling device according to claim 16, **characterized by** the fact that the above-mentioned filling head (12) is adapted to the width of the substrate (1) to be treated and that a system of rapid fixation permits switching from one filling head to another.

21. The filling device according to claim 16, **characterized by** the fact that the above-mentioned roller (3) comprises fins parallel to the axis of the roller in order to accentuate the displacement of the filling product (2).

22. The filling device according to claims 15 and 16, **characterized by** the fact that the above-mentioned scraper (9) is tangentially placed on the upper part of the displacing element (3) in a manner to cause the evacuation of the air bubbles (6).

23. The filling device according to any one of claims 12 to 22, **characterized by** the fact that the above-mentioned substrate (1) is a printed circuit.

24. The filling device according to any one of claims 12 to 23, **characterized by** the fact that the above-mentioned filling head (12) containing the filling product (2) is closed.

25. The filling device according to any one of claims 12 to 23, **characterized by** the fact that the above-mentioned filling head (12) containing the filling product (2) is closed with creation of a level of vacuum in its part situated above the filling product (2) to promote the evacuation of the extracted air from the zones to be filled (4) of the substrate (1).

26. An apparatus associated with a filling device according to any of claims 12 to 25, **characterized by** the fact that it is composed :
- of the conveyor (11), that assures the translation A of the substrates (1) below the filling head (12),
- of a feeding conveyor (20) situated upstream from the conveyor (11) to transport the substrates to be filled (1) to the conveyor (11) below the filling head (12),
- and of an evacuation conveyor (30) situated downstream from the conveyor (11) for recuperating the substrates (1) that have just been filled by the above-mentioned filling head (12).

27. The apparatus according to claim 26, **characterized by** the fact that the conveyor (11) is constituted by an endless belt (110) and that engaged around two cylinders (111 and 112), at least one of which is driving, is associated at the entrance to at least one pressing cylinder (120a and 120b) arranged above the belt (110) in order to maintain under pressure and to drive the substrates (1) that have just exited the admission conveyor (20) onto the belt (110) below the filling head (12).

28. The apparatus according to claim 26, **characterized by** the fact that the feeding conveyor (20) is the roller type and comprises a centering device (21) formed from two guiding rails (21a and 21b) bordered on the interior by rolling rollers and that, mounted adjustable in width, permit to appropriately position the substrates (1) before their admission under the filling head (12) on the conveyor (11).

29. The apparatus according to claim 26, **characterized by** the fact that it comprises a continuous cleaning device (22) for the endless belt (110) that, constituted by at least a blade (22a or 22b) is arranged to push onto the external surface of the belt (110) under the conveyor (11) to form scrapers.

30. The apparatus according to claim 26, **characterized by** the fact that the evacuation conveyor (30) is of the belt type and permits transportation of the substrates (1) that have just been filled by the head (12) to another treatment unit.

## Patentansprüche

1. Verfahren zum direkten Füllen ohne Luftblase und bei Überdicke der Zwischenspuren oder der Zonen (4), die sich im Vergleich zu der Fläche eines Substrates oder einer Leiterplatte (1) im Hohlraum befinden und nicht durch ein viskoses Produkt (2) auf der anderen Seite einmünden, **dadurch gekennzeichnet, dass** es in folgendem besteht:
- das Füllprodukt (2) im Bereich der zu füllenden Zonen (4) in Bewegung zu setzen, durch die hydrodynamische Einwirkung einer in Drehung befindlichen Rolle (3), deren Achse sich im Vergleich zu der Vorrichtung senkrecht zu der Bewegung des Substrates befindet und parallel zu dem Substrat und einen Druckausgleich zwischen dem unteren Bereich und dem oberen Bereich der Rolle zu erzeugen, dank der gemeinsamen Einwirkung der Rolle (3) und eines Rakelmesserelementes (7) und zwar so, dass das Gas (5), das sich in den hohlen Zonen (4) befindet, in Form von Blasen (6) abgeführt wird und dass es durch ein Füllprodukt (2) ersetzt wird
- und die Dicke des Produktes (2) durch das Rakelmesserelement (7) auf die Oberfläche des Substrates (1) einzustellen.

2. Verfahren zum Füllen gemäß Anspruch 1, **dadurch gekennzeichnet, dass** es sukzessive aus Folgendem besteht:
- Abdichten der zu füllenden Zone (4) bei jedem Eintritt von externem Gas in die Zone (4) durch Verteilung des Produktes (2) auf der Oberfläche des Substrates (1) und zwar so, dass die zu füllenden Zonen (4) des externen Gases gefüllt werden und das Produkt (2) zur Verfügung gestellt wird.
- Inbewegungsetzen des Produktes (2) im Bereich der zu füllenden Zonen (4) und zwar so, dass das Gas (5), das sich in den zu füllenden Zonen befindet (4). unter dem Füllprodukt (2), in Form von Blasen abgeführt wird,
- Ersetzen des Gases (5), das in Form von Blasen (6) abgeführt wird, durch das Füllprodukt (2),
- und Einstellen der Dicke des Produktes (2) auf die Oberfläche des Substrates (1).

3. Verfahren zum Füllen gemäß Anspruch 1, **dadurch gekennzeichnet, dass** das Inbewegungsetzen des Produktes (2) im Bereich der zu füllenden Zone (4) durch eine hydrodynamische Einwirkung erreicht wird.

4. Verfahren zum Füllen gemäß Anspruch 1, **dadurch gekennzeichnet, dass** es in der Blockierung der Gasblasen (6) besteht, die von dem Mittel zum Inbewegungsetzen (3) des Füllproduktes (2) abgeschieden werden, mit Hilfe eines Abstreifers (9), damit sie nicht erneut in die zu füllenden Zonen (4) getrieben werden.

5. Verfahren zum Füllen gemäß Anspruch 1, **dadurch gekennzeichnet, dass** die besagten zu füllenden Zonen (4) nicht in die andere Seite des Substrates (1) münden und dass sie eine große Länge von mehreren Millimetern bis zu mehreren Dezimetern aufweisen und dass sie ein Aussehen aufweisen können, das durch die Tiefe der Zone definiert wird in Bezug auf die Oberfläche, die durch die kleinste Öffnungsabmessung, kleiner 1, geteilt wird.

6. Verfahren zum Füllen gemäß Anspruch 1, **dadurch gekennzeichnet, dass** die Geschwindigkeit der Bewegung des Füllproduktes (2) einstellbar ist.

7. Verfahren zum Füllen gemäß Anspruch 1, **dadurch gekennzeichnet, dass** das Inbewegungsetzen des Füllproduktes (2) im Bereich der zu füllenden Zone (4) durch eine hydrodynamische Einwirkung einer in Drehung befindlichen Rolle (3) erreicht wird, deren Achse sich in Bezug auf die Vorrichtung senkrecht zu der Bewegung des Substrates befindet und parallel zu dem Substrat und gemäß der Richtung so, dass die tangentiale Bewegung der Rolle im Bereich der zu füllenden Zone der Verschieberichtung des Substrates (1) gegenüber liegt.

8. Verfahren zum Füllen gemäß Anspruch 1, **dadurch gekennzeichnet, dass** es ein Verschiebemittel (11) bei Translation des Substrates (1) mit der Einwirkung eines Füllkopfes (12) verbindet, der sich auf das Substrat (1) stützt und das Füllmittel (2) enthält, wobei der besagte Kopf (12) die Erzeugung eines positiven Druckausgleichs zwischen dem unteren Bereich und dem oberen Bereich des Mittels zum Inbewegungsetzen (3) des Produktes (2) ermöglicht, dank der gemeinsamen EinEinwirkung des besagten Mittels zum Inbewegungsetzen (3) des Füllproduktes (2) und eines Rakelmesserelementes (7), die auf diese Weise einen angrenzenden unteren Überdruckbereich (C) bildet, der vollkommen von dem Füllprodukt besetzt ist und dass das Mittel zum Inbewegungsetzen (3) eine Umwälzung des Füllproduktes (3) im Bereich der zu füllenden Zone in der Richtung bewirkt, die der Verschiebung des Substrates in Bezug auf den Füllkopf (12) entgegengesetzt ist und auf diese Weise ein oberer Bereich mit einem geringeren Druck (D) gebildet wird und zwar so, dass das Gas (5), das sich in den zu füllenden Zonen (4) befindet, abgeführt wird und durch das Füllprodukt (2) je nach der Verschiebung des Substrates (1) ersetzt wird.

9. Verfahren zum Füllen gemäß Anspruch 1, 7 und 8 **dadurch gekennzeichnet, dass** die Rolle (3), die das Inbewegungsetzen des Füllproduktes (2) gewährleistet, in dem oben genannten Füllkopf (12) enthalten ist.

10. Verfahren zum Füllen gemäß Anspruch 8 und 9, **dadurch gekennzeichnet, dass** die Rotationsgeschwindigkeit und/oder der Durchmesser der oben genannten Rolle (3), die in dem Füllkopf (12) enthalten ist, so regulierbar sind, dass der Druckausgleich des angrenzenden Überdruckbereiches (C) in Bezug auf die Zone mit dem niedrigsten Druck (D) eingestellt werden kann und eine Kontrolle des Überlaufens des Produktes (2) unter das Rakelmesserelement (7) im Bereich der zu füllenden Zonen (4) ermöglicht wird und die Schleppeinwirkung des besagten unteren Rakelmesserelementes (7) ausgeglichen wird.

11. Vorrichtung zum Füllen ohne Siebdruckmaske oder -blende von Zonen, die sich in Hohlräumen befinden (4) im Vergleich zu der Oberfläche eines Substrates (1) und nicht in die andere Seite des Substrates (1) münden und sich auf einer großen Länge, von mehreren Millimetern bis zu mehreren Dezimetern ausbreiten können und ein Aussehen aufweisen können, das durch die Tiefe der Zone definiert wird in Bezug auf die Oberfläche, die durch die kleinste Öffnungsabmessung, kleiner 1, geteilt wird, mit einem viskosen Füllprodukt (2), bei Translation des Substrates in Bezug auf die Oberfläche des Substrates (1) und durch die Umsetzung des Füllverfahrens gemäß einem der Ansprüche 1 bis 11, durch die tatsache **gekennzeichnet**, dass es in der Reihenfolge gemäß der Verschieberichtung in Bezug auf die Füllvorrichtung in Bezug auf das Substrat (1) Folgendes verbindet:
- ein Element (10) zur Verteilung des zu füllenden Produktes (2) auf der Oberfläche des Substrates (1),
- ein Element zum Inbewegungsetzen (3) des Füllproduktes (2) im Bereich der zu füllenden Zone (4), das man durch die hydrodynamische Einwirkung eine Rotationsrolle (3) erreicht, deren Achse sich in Bezug auf die Vorrichtung senkrecht zu der Bewegung des Substrates befindet und parallel zu dem Substrat und zur Erzeugung eines Druckausgleichs zwischen dem unteren und dem oberen Bereich der Rolle, dank der gemeinsamen Einwirkung der Rolle (3) und eines Rakelmesserelementes (7)und zwar so, dass das Gas (5), das sich in den Zonen der Hohlräume (4) befindet, in Form von Blasen abgeführt wird und dass es durch ein Füllprodukt (2) ersetzt wird.
- ein Element (7) zur Einstellung der Dicke oder des Rakelns des Überschusses des Füllproduktes (2) und zwar so, dass das oben genannte Füllprodukt (2) ständig in Kontakt mit der zu füllenden Zone (4) bleibt und zwar von Beginn des Füllvorgangs bis zum Ende des Rakelns des Überschusses.

12. Füllvorrichtung gemäß Anspruch 11, durch die tatsache **gekennzeichnet**, dass das Element zum Inbewegungsetzen (3) aus einer in Rotation befindlichen Rolle (3) besteht.

13. Füllvorrichtung gemäß Anspruch 11, durch die tatsache **gekennzeichnet**, dass die Vorrichtung symmetrisch ist und zwar so, dass sie in beiden Richtungen betrieben werden kann und auf einer Siebdruckmaschine eingesetzt werden kann.

14. Füllvorrichtung gemäß Anspruch 11, durch die tatsache **gekennzeichnet**, dass die besagte Translationsbewegung des Füllproduktes (2) in Bezug auf die Oberfläche des Substrates (1) durch Aufrechterhalten der festen Position der Vorrichtung zum Füllen des Produktes (2) erreicht wird, wohingegen das Substrat (1) beweglich ist.

15. Füllvorrichtung gemäß Anspruch 11 und 12, durch die tatsache **gekennzeichnet**, dass sie einen Abstreifers (9) umfasst, der zur Blockierung der Blasen (6) bestimmt ist, die von dem oben genannten Element zum Inbewegungsetzen (3) abgeschieden werden

16. Füllvorrichtung gemäß einem der Ansprüche 11 bis 15, durch die tatsache **gekennzeichnet**, dass sie aus Folgendem besteht:
- einem Füllkopf (12), der Folgendes umfasst:
a) eine Kammer (13), die das Füllprodukt (12) enthält, wobei die besagte Kammer (13) im unteren Bereich durch einen Abstreifer (7) begrenzt wird, der um einen Winkel _ kleiner oder gleich 90° geneigt ist und im oberen Bereich durch einen Abstreifer (10), der in derselben Richtung um einen Winkel _ gleich oder größer 90° geneigt ist
b) eine Rolle (3) zum Inbewegungsetzen des Produktes (2), die sich zwischen dem Abstreifer (7) und (10) befindet und sich in der Richtung dreht, so dass die tangentiale Bewegung der Rolle (3) im Bereich der zu füllenden Zone der Translationsbewegung (Pfeil A) des Substrates in Bezug auf die Füllvorrichtung entgegengesetzt ist.
- und ein Mittel zur Translationsverschiebung (11) des Substrates (1), das eine fortlaufende Rollfunktion (Pfeil A) des Mittels unter dem oben genannten Füllkopf (12) ermöglicht.

17. Füllvorrichtung gemäß Anspruch 16, durch die tatsache **gekennzeichnet**, dass das oben genannte Mittel zur Translationsverschiebung (11) des Substrates (1) ein Transportband ist.

18. Füllvorrichtung gemäß Anspruch 16, durch die tatsache **gekennzeichnet**, dass der oben genannte Füllkopf (12) mit einem Absperrungselement ausgerüstet ist, das in seinem unteren Teil angeordnet ist.

19. Füllvorrichtung gemäß Anspruch 16, durch die tatsache **gekennzeichnet**, dass der oben genannte Füllkopf (12) in der Länge verstellbar ist entsprechend der Breite des zu behandelnden Substrates (1).

20. Füllvorrichtung gemäß Anspruch 16, durch die tatsache **gekennzeichnet**, dass der oben genannte Füllkopf (12) an die Breite des zu behandelnden Substrates (1) angepasst ist und dass ein System zur schnellen Befestigung den Übergang von einem Füllkopfe zum anderen ermöglicht.

21. Füllvorrichtung gemäß Anspruch 16, durch die tatsache **gekennzeichnet**, dass die oben genannte Rolle (3) Flügel umfasst, die sich parallel zur Achse der Rolle befinden und zwar so, dass das Inbewegungsetzen des Füllproduktes (2) verstärkt wird.

22. Füllvorrichtung gemäß Anspruch 15 und 16, durch die tatsache **gekennzeichnet**, dass der oben genannte Abstreifer (9) tangential auf dem oberen Teil des Elementes zum Inbewegungsetzen (3) positioniert ist und zwar so, dass er das Abführen der Luftblasen (6) bewirkt.

23. Füllvorrichtung gemäß einem der Ansprüche 12 bis 22, durch die tatsache **gekennzeichnet**, dass das oben genannte Substrat (1) eine Leiterplatte ist.

24. Füllvorrichtung gemäß einem der Ansprüche 12 bis 23, durch die tatsache **gekennzeichnet**, dass der oben genannte Füllkopf (12), der das Füllprodukt (2) enthält, geschlossen ist.

25. Füllvorrichtung gemäß einem der Ansprüche 12 bis 23, durch die tatsache **gekennzeichnet**, dass der oben genannte Füllkopf (12), der das Füllprodukt (2) enthält, geschlossen ist und eine Vakumstufe in seinem Teil, oberhalb des Füllproduktes (2) bildet, um das Abführen der Luft zu begünstigen, die in den zu füllenden Zonen (4) des Substrates (1) ausgeschieden wurde.

26. Ausrüstung, die gemäß einem der Ansprüche 12 bis 25 mit einer Füllvorrichtung verbunden ist, , durch die tatsache **gekennzeichnet**, dass sie aus Folgendem besteht:
- aus dem Förderband (11), das die Translation A der Substrate (1) unter dem Füllkopf (12) gewährleistet.
- aus einem Zubringerband (20), das sich oberhalb des Förderbandes (11) befindet, um die zu füllenden Substrate (1) zu dem Förderband (11)unter dem Füllkopf (12) zu befördern.
- und einer Entleerungseinrichtung (30), die sich unter dem Förderband (11) befindet, um die Substrate (1) zurück zu gewinnen, die durch den oben genannten Füllkopf (12) gefüllt werden.

27. Ausrüstung gemäß Anspruch 26, durch die tatsache **gekennzeichnet**, dass das Förderband (11) aus einem endlosen Transportband (110) besteht, das um zwei Zylinder (111 und 112) herum getrieben wird, von denen mindestens einer ein Motor ist und am Eingang mit mindestens einer Eindrückwalze (120a oder 120b) verbunden ist, die über dem Transportband (110) angeordnet ist und zwar so, dass das Substrat (1), das aus dem Zubringerband (20) austritt, unter Druck gehalten wird und dass es auf dem Transportband (110), unter dem Füllkopf (12) angetrieben wird.

28. Ausrüstung gemäß Anspruch 26, durch die tatsache **gekennzeichnet**, dass das Zubringerband (20) Rollen hat und eine Zentriervorrichtung (21) umfasst, die aus zwei Führungsschienen (21a und 21b) besteht, die innen mit Laufrollen eingefasst sind und so montiert sind, dass ihre Breite regelbar ist und eine zweckmäßige Positionierung der Substrate (1) vor ihrem Eintritt unterhalb des Füllkopfes (12) auf dem Förderband (11) ermöglichen.

29. Ausrüstung gemäß Anspruch 26, durch die tatsache **gekennzeichnet**, dass sie eine Vorrichtung zur fortlaufenden Reinigung (22) des Endlosbandes (110) umfasst, das aus mindestens einer Klinge (22a oder 22b) besteht und gestützt auf der Außenseite des Bandes (110), unterhalb des Förderbandes (11) angeordnet ist, um Abstreifer zu bilden.

30. Ausrüstung gemäß Anspruch 26, durch die tatsache **gekennzeichnet**, dass die Entleerungseinrichtung (30) Förderbänder umfasst und einen Transport der Substrate (1) ermöglicht, die durch den Kopf (12) gefüllt werden, zu einer anderen Behandlungseinheit ermöglicht.
